(19) Europäisches Patentamt
European Patent Office
Office européen des brevets

(11) **EP 2 312 751 A1**

(12) **EUROPEAN PATENT APPLICATION**

(43) Date of publication:
**20.04.2011 Bulletin 2011/16**

(51) Int Cl.:
***H03F 3/45*** (2006.01)

(21) Application number: **09172923.6**

(22) Date of filing: **13.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Sequans Communications Reading RG41 5RB (GB)**

(72) Inventors:
• **Li, Mengxiong**
  **Reading, Berkshire RG41 5RB (GB)**
• **Shafeeu, Hassan**
  **Reading, Berkshire RG41 5RB (GB)**

(74) Representative: **Neobard, William John et al Kilburn & Strode LLP
20 Red Lion Street
London WC1R 4PJ (GB)**

(54) **Differential amplifier with common-mode feedback**

(57)    A fully differential amplifier comprises a first gain stage (11-13,15,16), a second gain stage (21,22), an active feedforward stage (23,24) and a common mode feedback stage (25,26,41-48). As shown in fig. 1, the first gain stage (11-13,15,16) comprises a source-coupled pair of NMOS transistors (11,12) having their sources connected to a current source (13), while their drains are connected to a pair of load transistors (15,16). The amplified differential output signal is obtained across the output nodes (31,32) to which are coupled the outputs of the second gain stage (21,22) and the outputs of the active feedforward stage (23,24). As shown in fig. 3, the common mode feedback stage comprises two differential amplifier stages (43,44 and 45,46), two diode-connected load transistors (41,42) and two feedforward transistors (31,32). Each one of the two differential amplifier stages receives a common reference voltage (Vref). The other input of each differential amplifier stage is connected to a respective output terminal (31,32) of the fully differential amplifier shown in fig. 1. One of the diode-connected load transistors (41) is connected to the pair of load transistors (15,16) to form a current mirror, in order to control the common mode voltage at the amplifier outputs (31,32) via the load transistors (15,16) of the first gain stage. This diode-connected transistor (41) is simultaneously connected to the drains of a pair of feedforward transistors (25,26) providing a DC path between the source terminals of the active feedforward stage (23,24) and a reference potential (Vss).

Figure 1

**Description**

The invention relates to the field of amplification and to amplifiers

In many amplifiers today, major requirements are for high speed and high gain.

This is true for many applications, including by way of example only- applications such as analog-to-digital converters (ADC), automatic-gain-control (AGC) and analog filters. High gain can be achieved by cascading individual gain stages. However this technique introduces low frequency poles and produces negative phase shift. Frequency compensation schemes are thus needed for such multistage amplifiers for stable operation in closed loop. Many reported frequency compensation schemes are a variation of the basic Miller compensation for a two-stage amplifier. In a Miller compensated amplifier, the dominant pole is pushed to lower frequencies due to the Miller effect (pole splitting), resulting in lower bandwidth structures. Also, a right-half-plane zero is created which degrades the phase response. A nulling resistor may be used to cancel the effect of the right-half-plane zero.

Operational amplifiers are the basic building blocks the monolithic analog and mixed-mode signal processing circuits. A fully differential architecture for these amplifiers in most cases is necessary in modern integrated circuits in view of their relatively large output swings and low susceptibility to common-mode noise. An issue with differential circuits is the need for a common-mode feedback circuit to control the common-mode output voltage. The common-mode feedback circuit operates to stabilize the output common-mode potential by sensing it and controlling it to make it equal to the desired common-mode potential, or reference voltage.

Passive feedforward compensation has been seen in literature, using a capacitor to bypass a stage in the amplifier at high frequencies, thereby eliminating the pole created in that stage. Active feedforward compensation instead provides a high frequency signal path by using feedforward transistors to bypass one or more stages in the amplifiers, therefore achieving frequency compensation.

For fully differential amplifiers, frequency compensation schemes need to be applied for both the differential amplifier and common-mode feedback circuit since each forms its own feedback loop. In the case of Miller frequency compensation, it generally poses more difficulties for the compensation of common-mode feedback loop than for the differential one because of the additional poles in the former.

Techniques were reported for active feedforward compensation in single-ended operational amplifiers without use of Miller capacitors. However, active feedforward frequency compensation without a Miller capacitor has not been reported for a fully differential design. There is a need to consider how frequency compensation could be implemented to satisfy simultaneously the stability requirements of the main differential gain stage and common-mode feedback stage in fully differential amplifiers. Challenges still remain especially when proper gain and decent bandwidth arc requested in common-mode feedback circuit thus multi gain stage has to be employed.

Embodiments provide improved techniques for performing frequency compensation for both main differential gain stage and common-mode feedback circuit in fully differential amplifiers.

Accordingly there is provided an amplifier having a first gain stage, a second gain stage and an active feedforward stage, wherein the first gain stage is a differential stage having first and second input nodes, and the second gain stage has first and second output nodes, the active feedforward stage having first and second circuitry, the first circuitry having a control node coupled to the first input node and a controlled path coupled to the second output node, and the second circuitry having a control node coupled to the second input node and a controlled path coupled to the first output node.

Both controlled paths in first and second circuitry may share a common source node whose voltage potential is defined by active feedforward stage in common-mode feedback circuit.

The first gain stage of the main differential amplifier may comprise a source-coupled pair with a current source connecting the common sources to a first supply rail, and a load pair connecting the drains of the source-coupled pair to a second supply rail, the load pair being of complementary type to the source-coupled air.

The second gain stage of the main differential amplifier may comprise a simple differential common source amplifier with the common source connecting to the second supply rail and drains connecting to the first and second output nodes, respectively.

The amplifier, in an embodiment, has a common-mode feedback circuit comprising a high gain stage and an active feedforward stage. It senses and averages the first and second output nodes in main differential amplifier and feeds back a first control parameter and a second control parameter to stabilize the output common mode voltage.

The high gain stage of the common-mode feedback circuit has inputs connected to the first and second output nodes, having a reference connection, and operable to feedback a first control parameter to the first gain stage in the main differential amplifier to control the common-mode at the first and second output nodes.

The high gain stage of the common-mode feedback circuit may comprise two source-coupled pairs, first devices of each pair having gates connected to the first and second output nodes and controlled paths connected to a diode-strapped transistor of a current mirror, which includes the load pair of the first gain stage in the main differential amplifier. The second devices of each pair having gates connected to the reference voltage node and controlled path connected to a second diode-strapped transistor. The active feedforward stage of the common-mode feedback circuit has inputs connected to the first and second output nodes in the main differential amplifier, having an output, the second control parameter connected to the common source node of the controlled path of the first circuitry and of the second circuitry.

The active feedforward stage of the common-mode feedback circuit may comprise two active transistors with both sources connected to the first supply rail and drains connected as the output of the active feedforward stage, the second control parameter.

A purely illustrative embodiment of the invention will now be described with reference to the accompanying drawings, in which:

Fig 1 shows a schematic drawing of a differential amplifier,
Fig. 2 shows a small-signal representation of the amplifier of Fig 1; and
Fig, 3 shows a common-mode feedback control circuit for use in the amplifier of Fig 1.

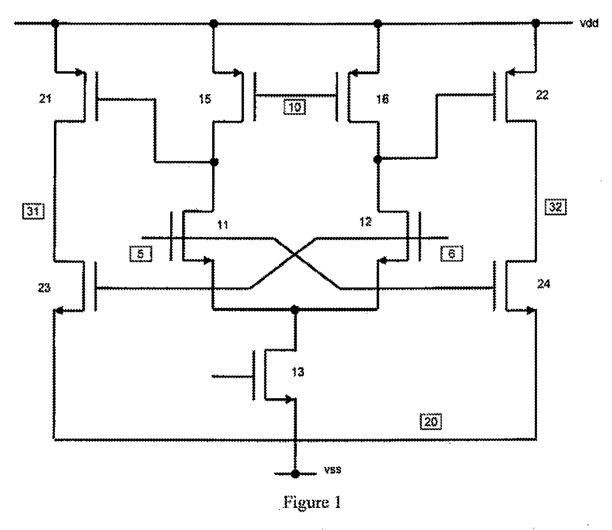

Refer to Fig.1, a differential amplifier I has a first gain stage having a pair of source-coupled NMOS transistors 11, 12, having PMOS transistor loads 15,16 whose sources are coupled to a positive rail Vdd. The common sources of the first and second NMOS transistors 11,12 are coupled to a negative rail Vss via a bias NMOS transistor 13. The gates of the NMOS transistors. 11,12 are connected to first and second circuit input nodes 5,6 respectively. The gates of the PMOS transistor loads 15, 16 arc connected in common to a node 10.

The junction between the first NMOS transistor 11 and its load 15 is connected to the gate of a first PMOS transistor 21 of a second gain stage, and similarly the junction between the second NMOS transistor 12 and its load 16 is connected to the gate of a second PMOS transistor 22 of the second gain stage. The PMOS transistors 21,22 have sources coupled to the positive rail Vdd, and drains connected to first and second output nodes 31, 32.

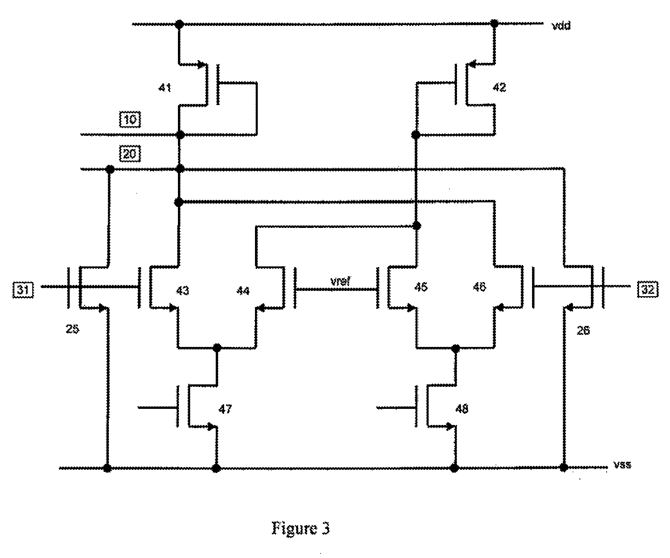

The output nodes 31, 32 are also connected to the respective drains of first and second feedforward NMOS transistors 23, 24. The first feedforward NMOS transistor 23 has its gate coupled to the second input node 6, and the second feedforward NMOS transistor 24 has its gate coupled to the first input node 5. The sources of the feedforward NMOS transistors 23, 24 are coupled in common to a node 20, that will be discussed with reference to Fig 3.

Normally in a conventional two stage amplifier, a Miller capacitor would be fitted across the gate and drain of PMOS transistors 21, 22 for frequency compensation. However in the proposed amplifier, frequency compensation is achieved by the active feedforward path formed by NMOS transistors 23, 24.

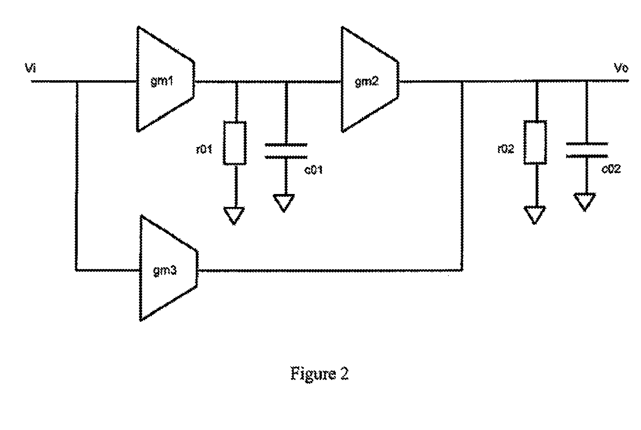

The small signal analysis of the proposed two stage amplifier in Fig.1 is shown in Fig.2, where $g_{mi}$, ($i$=1, 2,3) denotes the transconductance of the transistor 11 (12), 21 (22) and 23 (24);
$r_{0i}$ $C_{0i}$ are the total output conductance and capacitance at the output node of i ($i$ =1, 2) gain stage.

The overall transfer function of the differential amplifier is

$$H(s) = \frac{g_{m1}r_{01}g_{m2}r_{02} + g_{m3}r_{02}\left(1 + \dfrac{s}{\omega_{p1}}\right)}{\left(1 + \dfrac{s}{\omega_{p1}}\right)\left(1 + \dfrac{s}{\omega_{p2}}\right)} \qquad (1)$$

There are two poles $\omega_{pi} = 1/r_{01}C_{01}$, $\omega_{p2} = 1/r_{02}C_{02}$ in the transfer function and a LHP (Left Half Plane) zero created by the feedforward path. The DC gain is given by ($g_{m1}r_{01}g_{m2}r_{02} + g_{m3}r_{03}$). The location of the LHP zero is

$$z_1 = -\omega_{p1}\left(1 + \frac{g_{m1}r_{01}g_{m2}r_{02}}{g_{m3}r_{02}}\right) \cong -\frac{g_{m1}}{C_{01}}\frac{g_{m2}}{g_{m3}} \qquad (2)$$

If the dominant pole is located at $\omega_{p1}$, and the frequency locations of the second pole $\omega_{p2}$ and zero $z_1$ are higher than that of $\omega_{p1}$, second gain stage and the feedforward stage can then be deliberately designed such that the negative phase shift due to $\omega_{p2}$ is compensated by the positive phase shift of the LHP zero. As long as the frequency of $\omega_{p2}$ exactly coincides with that of the LHP zero, the amplifier can be analyzed as a one pole system with the unit gain frequency given by $\omega_{GBW} = g_{m2}r_{02}(g_{m1}/C_{01})$.

$$\frac{C_{02}}{C_{01}} = \frac{g_{m3}}{g_{m1}g_{m2}r_{02}} \qquad (3)$$

This compensation scheme results in an amplifier with fast frequency response and high gain. The bandwidth improvement is achieved by cancelling the non-dominant pole, while not pushing the dominant pole toward lower frequencies, as in the case of amplifiers with Miller compensation. There can be a substantial reduction in power consumption and silicon area, especially as compared to multistage amplifiers, which normally use two or more Miller capacitors for phase compensation.

For simplicity, it has been assumed that the first, second and feedforward stage of the amplifier are first order response, as shown in Fig.2. If second order effects of the first gain stage arc considered, then the resulting transfer function would have 3 poles and 2 zeros. In principal the number of LHP zeros created by the feedforward path is equal to the order of the first gain stage. Practically it is preferable that the second stage and feedforward stage employ a simple gain stage so that the non-dominant poles are located after the unit-gain bandwidth of the overall amplifier in order to minimize phase degradation.

Referring to Fig 3, an exemplary common-mode feedback circuit 40 has two source-coupled differential pairs, comprising first-fourth NMOS transistors 43,45; 44, 46 each with their common source nodes coupled via a respective bias NMOS transistors 47,48 to the negative rail Vss. The first and fourth NMOS transistors 43, 46 have gates connected respectively to the first output node 31 and the second output node 32 of the differential amplifier 1. The gates of the second and third NMOS transistors 44, 45 are connected in common to an input terminal, in use receiving a common-mode target voltage Vref.

The drains of the first and fourth NMOS transistors 43, 46 are connected to the positive rail Vdd via a load 41, being a diode-strapped PMOS transistor. Likewise, the drains of the second and third NMOS transistors 44, 45 are connected to the positive rail Vdd via a load 42, being a diode-strapped PMOS transistor. The drains of the first and fourth NMOS transistors 43, 46 are further connected to the node 10 of the differential amplifier 1, whereby the diode-strapped transistor 41 forms the control element of a current mirror, whose mirroring elements arc the load transistor 15,16 of the differential amplifier 1.

The active feedforward stage of the common-mode feedback circuit in Fig.3 comprises the controlled paths of first and second further NMOS transistors 25, 26. The drains of NMOS transistors 25, 26 are connected to node 20 in the differential amplifier 1. The sources of NMOS transistors 25, 26 are coupled to the negative rail Vss. The first further NMOS transistor 25 has its gate connected to the first output node 31 of the differential amplifier 1, and the second further NMOS transistor 26 has its gate connected to the first output node 32 of the differential amplifier 1.

The basic principle of operation of the common-mode feedback circuit shown in Fig.3 is as follows:

   i) the common-mode voltage at nodes 31, 32 of the differential amplifier 1 output is sensed and compared to the common-mode target voltage (Vref) by the quad differential pairs 43-46.
   ii) The resulting common-mode "error signal" is fed back to the differential amplifier by means of the current mirror 41, 15, 16.
   iii) The effect is that the common-mode voltage at the output nodes 31, 32 becomes equal to the target voltage Vref.

In this embodiment, the common-mode feedback circuit has three gain stages, namely, the first-fourth NMOS transistors herein also referred to as a differential quad 43-46 in, as the first stage, a second stage of PMOS transistor 15 (respectively 16) and a third stage of PMOS transistor 21 (respectively 22). The diode connected PMOS load pair 41 (respectively 42) give relatively low impedance at node 10 for proper balance between gain and bandwidth of the common-mode feedback circuit. The common-source gain stages of transistors 15 (respectively 16) and 21 (respectively 22) in the differential amplifier 1 ensures adequate common-mode gain with transistors 15, 16, 21 and 22 shared by the common-mode feedback/control stage 40 and the differential amplifier 1. Moreover, the feedback gain provided by transistors 15 (respectively 16) is necessary for the common-mode voltage stability of the first stage of the differential amplifier 1.

This type of configuration, however, is associated with design difficulties relevant to frequency compensation because of additional poles in the common-mode feedback path. Besides the pole associated with the parasitic gate capacitance of transistors 21, (respectively 22) and the high output resistance of transistors 15 (respectively 16) and 11 (respectively 12), which is shared with the differential amplifier 1, the common-mode feedback circuit 40 has the poles introduced by parasitic gate capacitance of transistors 15 (respectively 16) and 41. Although the diode-connected PMOS 41 alleviates the resistance load associated with this node, the frequency compensation for the common-mode feedback still poses lot of design challenges considering the high speed application. For example, by means of the conventional Miller compensation or nested Miller compensation, capacitors across the gate-drain of transistor 21 (respectively 22) or across the output and common-mode feedback node would be physically large, and therefore occupies a large die area. In addition, the bandwidth of the circuit, not only the common-mode feedback circuit 40, but also the overall differential amplifier, can be considerably decreased due to pole split effects.

The beauty of the disclosed frequency compensation technique for the common-mode feedback circuit 40 is to introduce further active feedforward paths in the overall amplifier, by NMOS transistors 25 and 26.

By sharing the same idea of the active feedforward frequency compensation mentioned before, a high gain, low frequency signal path of the common-mode feedback circuit is formed by differential quad 43-46, diode connected PMOS load 41, common gate gain stages of transistors 15 (respectively 16) and 21 (respectively 22). The low gain, high frequency feedforward path is formed by transistor 25 (respectively 26). Benefiting from the feedforward path, a LHP zero can be created to cancel the non-dominant pole in the low frequency signal path.

For design consideration, the input stages of the common-mode feedback circuit in Fig.3 should have proper bias current and transistor size for fast frequency response. This ensures the pole associated with load 41 is after the unit gain bandwidth of the common-mode feedback circuit, otherwise two or more non-dominant poles located closely would make the frequency compensation much more complicated. Based on equation (3), as long as the design constraints for transistors 25 and 26 are met:

$$\frac{C_o}{C_p} = \frac{g_{m25}}{g_{m15}g_{m21}r_o} \qquad (3)$$

where

$C_o$, $C_p$ denote the total capacitance at the output node and the parasitic capacitance at the gate of transistor 21 (respectively 22);

$r_a$ is the parallel output resistance of 21, 22, 23, 24;

$g_{m25}$, $g_{m15}$, $g_{m21}$ are the trans-conductance of transistors 25 (and 26), 15 (and 16) and 21 respectively.

It is worth noting that any imperfections in pole-zero cancellation caused by process variations and different load conditions can result in a pole-zero doublet that might affect the performance of the amplifier. But as long as the pole-zero cancellation occurs at higher frequencies than the unit gain bandwidth, the effects of are negligible.

In the disclosed technique, the active feedforward compensation scheme is introduced to fully differential amplifier both for the main gain stages and common-mode feedback circuit. No Miller capacitor is required for the amplifier which

1) Improves unit gain bandwidth both for the differential amplifier and the common-mode feedback circuit.
2) Dramatically reduces silicon area because of the active implementation.

The amplifier of Fig 1 may function as an operational amplifier.

An embodiment of the invention has now been described. The invention is not limited to the described features but extends to the scope of the appended claims

**Claims**

1. An amplifier having a first gain stage, a second gain stage and an active feedforward stage, wherein the first gain stage is a differential stage having first and second input nodes, and the second gain stage has first and second output nodes, the active feedforward stage having first and second circuitry, the first circuitry having a control node coupled to the first input node and a controlled path coupled to the second output node, and the second circuitry having a control node coupled to the second input node and a controlled path coupled to the first output node.

2. An amplifier according to claim 1, having a common mode feedback stage connected to the first and second output nodes, having a reference connection, and operable to feedback a control parameter to the first gain stage to control the common mode voltage at the first and second output nodes.

3. An amplifier according to claim 1 or 2, wherein the first gain stage comprises a source-coupled pair with a current source connecting the commoned sources to a first supply rail, and a load pair connecting the drains of the source-coupled pair to a second supply rail, the load pair being of complementary type to the source-coupled pair.

4. An amplifier according to any preceding claim wherein the second gain stage comprises a simple differential common source amplifier with the common source connecting to the second supply rail and drains connecting to the first and second output nodes, respectively.

5. An amplifier according to claim 3, wherein the controlled path of the first circuitry and of the second circuitry extend between the respective output node and a common node, and the common node is connected to the first supply rail via the controlled path of first and second active devices each having a control node connected to a respective one of the first and second output nodes.

6. An amplifier according to claim 2 wherein the common mode feedback stage comprises two source-coupled pairs, first devices of each pair having gates connected to the first and second output nodes and controlled paths connected to a diode-strapped transistor of a current mirror, the second devices of each pair having gates connected to the reference voltage node and controlled path connected to a second diode-strapped transistor, the current mirror including the load pair of the first gain stage.

7. An amplifier according to claim 2, wherein the common-mode feedback circuit has a high gain stage with inputs connected to the first and second output nodes, having a reference connection, and operable to feedback a first control parameter to the first gain stage in the differential amplifier to control the common-mode at the first and second output nodes.

8. An amplifier according to claim 2 or 7, wherein common-mode feedback circuit has an active feedforward stage with inputs connected to the first and second output nodes of the differential amplifier, having an output, the second control parameter connected to the common source node of the controlled path of the first circuitry and of the second circuitry.

9. A method of processing a differential signal comprising:- amplifying the signal by

    i) applying it to a differential gain stage at first and second inputs, and
    ii) passing the resultant to a second gain stage having first and second outputs responsive respectively to the first and second inputs, and

providing frequency compensation by active feedforward circuitry controlling the first output in dependence on the signal at the second input and controlling the second output in dependence on the signal at the first input.

10. The method of claim 9, further comprising providing common mode feedback from the first and second outputs to feedback a control parameter to the differential gain stage in dependence on a reference input.

Figure 1

Figure 2

8

Figure 3

Europäisches
Patentamt

European
Patent Office

Office européen
des brevets

**EUROPEAN SEARCH REPORT**

Application Number

EP 09 17 2923

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/030275 A1 (VAN ZANTEN FRANCOIS [FR]) 7 February 2008 (2008-02-07) | 1-4,7, 9-10 | INV. H03F3/45 |
| Y | * figure 1 * | 6 | |
| A | * paragraph [0059] - paragraph [0062] * | 5,8 | |
| Y | US 2008/068083 A1 (SINGH PRATAP N [IN] ET AL SINGH PRATAP N [IN] ET AL) 20 March 2008 (2008-03-20) * figure 1 * | 6 | |
| Y | US 6 329 849 B1 (CZARNUL ZDZISLAW [JP] ET AL) 11 December 2001 (2001-12-11) * column 3, lines 16-20; figure 17 * | 6 | |
| X | WO 2006/102651 A1 (ASPENDOS COMM [US]; CAPOFREDDI PETER [US]; SHAEFFER DEREK K [US]; TITI) 28 September 2006 (2006-09-28) | 1,3-4,9 | |
| A | * figure 5c * | 2,5-8,10 | |
| X | US 2006/176115 A1 (ETOU TOSHIYUKI [JP]) 10 August 2006 (2006-08-10) | 1,3-4,9 | |
| A | * figure 1 * * paragraph [0028] - paragraph [0031] * | 2,5-8,10 | TECHNICAL FIELDS SEARCHED (IPC) H03F |
| X | BHARATH KUMAR THANDRI ET AL: "A Robust Feedforward Compensation Scheme for Multistage Operational Transconductance Amplifiers With No Miller Capacitors" IEEE JOURNAL OF SOLID-STATE CIRCUITS, IEEE SERVICE CENTER, PISCATAWAY, NJ, US, vol. 38, no. 2, 1 February 2003 (2003-02-01), XP011065959 ISSN: 0018-9200 | 1,3-4,9 | |
| A | * the whole document * | 2,5-8,10 | |
| A | US 2005/218985 A1 (LEBEDEV SEMYON [IL] ET AL) 6 October 2005 (2005-10-06) * figure 1a * | 1-10 | |

The present search report has been drawn up for all claims

| Place of search | Date of completion of the search | Examiner |
|---|---|---|
| Munich | 29 March 2010 | Dietsche, Stefan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

## ANNEX TO THE EUROPEAN SEARCH REPORT
## ON EUROPEAN PATENT APPLICATION NO.

EP 09 17 2923

This annex lists the patent family members relating to the patent documents cited in the above-mentioned European search report.
The members are as contained in the European Patent Office EDP file on
The European Patent Office is in no way liable for these particulars which are merely given for the purpose of information.

29-03-2010

| Patent document cited in search report | | Publication date | Patent family member(s) | | Publication date |
|---|---|---|---|---|---|
| US 2008030275 | A1 | 07-02-2008 | EP 1885057 A1<br>FR 2904739 A1 | | 06-02-2008<br>08-02-2008 |
| US 2008068083 | A1 | 20-03-2008 | NONE | | |
| US 6329849 | B1 | 11-12-2001 | JP 3557110 B2<br>JP 2000148262 A<br>KR 20000035417 A<br>TW 432791 B | | 25-08-2004<br>26-05-2000<br>26-06-2000<br>01-05-2001 |
| WO 2006102651 | A1 | 28-09-2006 | US 2006226901 A1 | | 12-10-2006 |
| US 2006176115 | A1 | 10-08-2006 | JP 2006222796 A | | 24-08-2006 |
| US 2005218985 | A1 | 06-10-2005 | NONE | | |

EPO FORM P0459

For more details about this annex : see Official Journal of the European Patent Office, No. 12/82